# EUROPEAN PATENT APPLICATION

(11) **EP 4 258 835 A1**
(43) Date of publication of application: **11.10.2023**
(21) Application number: 21902184.7
(22) Date of filing: 30.09.2021
(51) Int. Cl.: H05K 7/20

(54) **HEAT DISSIPATION APPARATUS AND ELECTRONIC DEVICE**

(30) Priority: 10.12.2020 CN 202011434328
(71) Applicant: ZTE Corporation, Shenzhen, Guangdong 518057 (CN)
(72) Inventor: CHENG, Lu, Shenzhen, Guangdong 518057 (CN)
(74) Representative: Savi, Massimiliano
(86) International application number: PCT/CN2021/122332
(87) International publication number: WO 2022/121476

(57) **Abstract**

A heat dissipation apparatus and an electronic device. The heat dissipation apparatus is applied to an electrical module (100) provided with a first heat source (130), and comprises a first heat dissipation body (210), which is provided with a first heat dissipation column (211), the first heat dissipation column (211) being configured to pass through a first through hole and connect to the first heat source (130), wherein the electrical module comprises a first electrical dielectric layer, the first electrical dielectric layer is provided with the first through hole, and the first heat source (130) covers the first through hole.

## Description

### CROSS-REFERENCE TO RELATED APPLICATION

This application is filed on the basis of Chinese patent application No. 202011434328.6 filed December 10, 2020, and claims priority to the Chinese patent application, the entire contents of which are incorporated herein by reference.

### TECHNICAL FIELD

Embodiments of the present disclosure relate to, but not limited to the technical field of heat dissipation, and more particularly, to a heat dissipation apparatus and an electronic device.

### BACKGROUND

In the field of electronic devices, with the increase of product service quantity and the improvement of system integration, the number of module components integrated into a device is gradually increasing. Consequently, the heat dissipation performance of the device is gaining increased attention from users. Currently, for the module components integrated in the device, a heat dissipation effect is often achieved by installing a heat radiator at the top of one module component. However, the heat radiator installed at the top of the module component tends to cause a problem of obstructing the installation of radiators on other module components.

### SUMMARY

The following is an overview of the subject matter described in detail herein. This overview is not intended to limit the scope of protection of the claims.

Embodiments of the present disclosure provide a heat dissipation apparatus and an electronic device that aim to address at least one of the related technical problems to a certain extent, including the problem of obstructing the installation of radiators on other module components caused by installing a heat radiator at the top of one module component.

In accordance with a first aspect of the present disclosure, an embodiment provides a heat dissipation apparatus applied to an electrical module provided with a first heat source. The electrical module includes a first electrical dielectric layer provided with a first through hole, and the first heat source covers the first through hole. The heat dissipation apparatus includes a first heat dissipation body provided with a first heat dissipation column, the first heat dissipation column being configured to pass through the first through hole to be connected to the first heat source.

In accordance with a second aspect of the present disclosure, an embodiment provides an electronic device including an electrical module and the heat dissipation apparatus as described in the first aspect. The electrical module includes a first electrical dielectric layer provided with a first heat source and a first through hole, and the first heat source covers the first through hole. The first heat dissipation column of the heat dissipation apparatus passes through the first through hole to be connected to the first heat source.

Other features and advantages of the present disclosure will be set forth in the following description, and partly become obvious from the description, or understood by implementing the present disclosure. The objects and other advantages of the present disclosure can be realized and obtained by the structure particularly pointed out in the description, claims and accompanying drawings.

### BRIEF DESCRIPTION OF DRAWINGS

The drawings are provided for a further understanding of the technical schemes of the present disclosure, and constitute a part of the description. The drawings and the embodiments of the present disclosure are used to illustrate the technical schemes of the present disclosure, and do not constitute a limitation to the technical schemes of the present disclosure.
Fig. 1 is a schematic diagram of an electrical module to which a heat dissipation apparatus provided by an embodiment of the present disclosure is applied;
Fig. 2 is a schematic diagram of a first heat source in an electrical module provided by an embodiment of the present disclosure;
Fig. 3 is a schematic diagram of a heat dissipation apparatus provided by an embodiment of the present disclosure;
Fig. 4 is a schematic diagram of a heat dissipation apparatus provided by another embodiment of the present disclosure;
Fig. 5 is a schematic diagram of a first heat dissipation body in a heat dissipation apparatus provided by an embodiment of the present disclosure;
Fig. 6 is a schematic diagram of a first heat dissipation body in a heat dissipation apparatus provided by another embodiment of the present disclosure;
Fig. 7 is a schematic diagram of a heat dissipation apparatus provided by another embodiment of the present disclosure;
Fig. 8 is a schematic diagram of a heat dissipation apparatus provided by another embodiment of the present disclosure;
Fig. 9 is a schematic diagram of a first heat dissipation body in a heat dissipation apparatus provided by another embodiment of the present disclosure; and
Fig. 10 is a schematic diagram of a heat dissipation apparatus provided by another embodiment of the present disclosure.

### DETAILED DESCRIPTION

In order to make the objects, technical schemes and advantages of the present disclosure clear, the present disclosure will be further described in detail in conjunction with the drawings and embodiments. It should be understood that the embodiments described here are only used to illustrate the present disclosure, and are not intended to limit the present disclosure.

It is to be noted, although functional modules have been divided in the schematic diagrams of apparatuses, in some cases, the modules may be divided in a different manner. The terms such as "first", "second" and the like in the description, the claims, and the accompanying drawings are used to distinguish similar objects, and are not necessarily used to describe a specific sequence or a precedence order.

The present disclosure provides a heat dissipation apparatus and an electronic device. By arranging a first heat dissipation column capable of passing through a first through hole on a first heat dissipation body, a first heat source arranged on a first electrical dielectric layer can be directly connected to the first heat dissipation column to realize heat dissipation. To be specific, in the case where the first heat source is located on one side of the first electrical dielectric layer, the heat dissipation apparatus may be installed on the other side of the first electrical dielectric layer to dissipate heat from the first heat source, such that the first heat dissipation body and the first heat source can be arranged on opposite sides of the first electrical dielectric layer. Since the heat dissipation apparatus is already arranged on one side of the first heat source in this case, a radiator is not required to be installed on the other side of the first heat source to dissipate heat from the first heat source, thereby solving the problem of obstructing the installation of radiators on other module components caused by installing a heat radiator at the top of one module component in some technical schemes.

The embodiments of the present disclosure will be further illustrated in conjunction with the drawings.

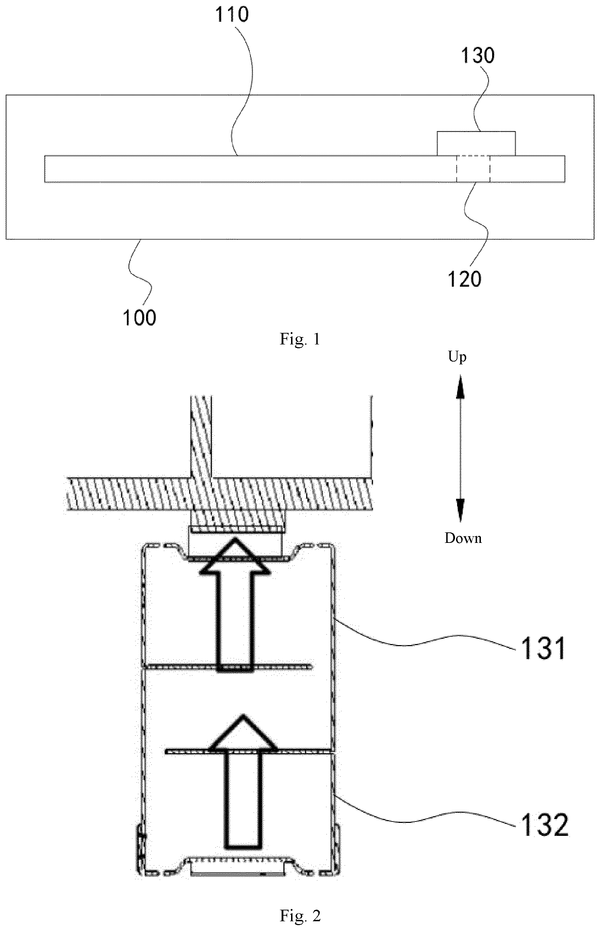

As shown in Fig. 1, Fig. 1 is a schematic diagram of an electrical module 100 to which a heat dissipation apparatus provided by an embodiment of the present disclosure is applied.

In an embodiment shown in Fig. 1, the electrical module 100 includes a first electrical dielectric layer 110, the first electrical dielectric layer 110 is provided with a first through hole 120 and a first heat source 130, and the first heat source 130 covers the first through hole 120.

In an embodiment, the first through hole 120 may be formed at any position on the first electrical dielectric layer 110. Accordingly, the first heat source 130 may be correspondingly arranged according to the forming position of the first through hole 120. Moreover, when more components are provided on the first electrical dielectric layer 110, the first electrical dielectric layer 110 may further be provided with a second through hole or more through holes. The function of the second through hole or more through holes is the same as that of the first through hole 120, both of which can play the role of through connection. For those having ordinary skills in the art, the number of through holes may be set according to the number of module components provided on the electrical module 100. The components provided on the electrical module 100 may include, but not limited to, a plurality of heat source components such as a second heat source, a third heat source, etc. Accordingly, a corresponding number of through holes may be set to match with all the heat source components mentioned above.

In an embodiment, the first electrical dielectric layer 110 may be, but not limited to, various types of substrate boards, wire boards or integrated boards. For example, the first electrical dielectric layer 110 may adopt common PCBs through which components are integrally arranged, or may adopt other boards with similar functions to the PCBs, which is not limited in this embodiment.

In an embodiment, the electrical module 100 may be, but not limited to, integrated components under various functional conditions and combinations of the integrated components. For example, the electrical module 100 may be a single first integrated component which at least includes a first electrical dielectric layer 110 and an integrated circuit laid on the first electrical dielectric layer 110. Alternatively, the electrical module 100 may also be a combined apparatus including a plurality of first integrated components, which is not limited in this embodiment.

In an embodiment, the first heat source 130 may be, but not limited to, various types of chip components, module components, etc., and the function of the first heat source 130 may be selected correspondingly according to the device application situation. For example, in order to realize device communication, an optical module component may be adopted to realize information transceiving to achieve a device communication effect. The chip components may be provided as control chips or chips that realize specific functions, which is not limited in this embodiment.

In an embodiment, referring to Fig. 2, when the first heat source 130 arranged on the electrical module 100 is an optical module, the first heat source 130 may be provided in two layers, namely, an upper-layer optical module 131 and a lower-layer optical module 132, which are connected in a cascade manner and have a unidirectional heat transfer channel, so that integrated heat dissipation can be performed on the first heat source. In practical application, more than two layers of optical modules may be provided, where all layers may be connected in a cascade manner, or some layers may be connected in a cascade manner, so the whole optical module has similar heat dissipation performance, which will not be repeated here.

The electrical module 100 and application scenarios described in the embodiments of the present disclosure are intended to illustrate the technical schemes in the embodiments of the present disclosure clearly, and are not intended to limit the technical schemes provided by the embodiments of the present disclosure. Those having ordinary skills in the art know that, with the evolution of the electrical module 100 and the emergence of new application scenarios, the technical schemes provided by the embodiments of the present disclosure are also applicable to similar technical problems.

Those having ordinary skills in the art can understand that the electrical module 100 shown in Fig. 1 does not constitute a limitation to the embodiment of the present disclosure and may include more or fewer components than shown, or combinations of parts, or different component arrangements.

Based on the structure of the above electrical module 100, various embodiments of the heat dissipation apparatus of the present disclosure are proposed.

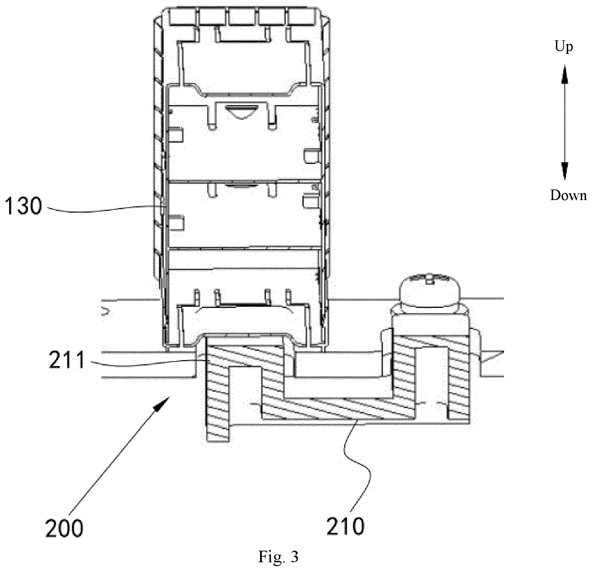

As show in Fig. 3, Fig. 3 is a schematic diagram of a heat dissipation apparatus 200 provided by an embodiment of the present disclosure. The heat dissipation apparatus 200 may be applied to the electrical module shown in Fig. 1.

Referring to Fig. 3, the heat dissipation apparatus 200 includes, but not limited to, a first heat dissipation body 210. The first heat dissipation body 210 is provided with a first heat dissipation column 211 configured to pass through the first through hole to be connected to the first heat source 130.

In an embodiment, by arranging the first heat dissipation column 211 capable of passing through the first through hole on the first heat dissipation body 210, the first heat source 130 arranged on the first electrical dielectric layer can be directly connected to the first heat dissipation column 211 to realize heat dissipation. In other words, in the case where the first heat source 130 is located on one side of the first electrical dielectric layer, the heat dissipation apparatus 200 may be installed on the other side of the first electrical dielectric layer to dissipate heat from the first heat source 130, such that the first heat dissipation body 210 and the first heat source 130 can be arranged on opposite sides of the first electrical dielectric layer. Since the heat dissipation apparatus 200 is already arranged on one side of the first heat source 130 at this time, a radiator is not required to be installed on the other side of the first heat source 130 to dissipate heat from the first heat source, thereby solving the problem of obstructing the installation of radiators on other module components caused by installing a heat radiator at the top of one module component in some technical schemes.

In an embodiment, the first heat dissipation body 210 and the first heat dissipation column 211 may be integrally connected or may be detachably connected. The former is suitable for the case where the electric module is fixed, that is, the heat dissipation apparatus 200 is specially configured to be matched with the electric module. It can be understood that integrated connection enables the heat dissipation apparatus to be matched with the existing electric module conveniently, helping to improve the product quality of the heat dissipation apparatus 200. While the latter is suitable for processing and thus can allow the heat dissipation apparatus to be matched with different electrical modules, that is, positions of the first heat dissipation body 210 and the first heat dissipation column 211 with respect to each other can be adapted to a corresponding electrical module by adjusting processing. For example, the first heat dissipation body 210 may be set in any three-dimensional shape, such as a rectangular body, a square body, a column body or the like. Similarly, the first heat dissipation column 211 may be installed at any position on the first heat dissipation body 210, and may be connected to the first heat dissipation body 210 at a certain angle. In this way, the first heat dissipation body 210 can still be ensured to have installation stability when the first heat dissipation column 211 passes through the first through hole to be connected to the first heat source 130. It can be understood that the first heat dissipation body 210 and the first heat dissipation column 211 of the heat dissipation apparatus 200 can be detachably connected to facilitate further processing, thereby improving the product quality of the heat dissipation apparatus 200.

In an embodiment, the first heat dissipation column 211 may be provided in multiple, and the specific number may be set according to the actual application situations. In this case, all the first heat dissipation columns 211 may be matched with corresponding through holes respectively, to provide a heat dissipation channel for a heat source configured for a corresponding through hole, which, on the whole, further improves the service performance of the electrical module and the device.

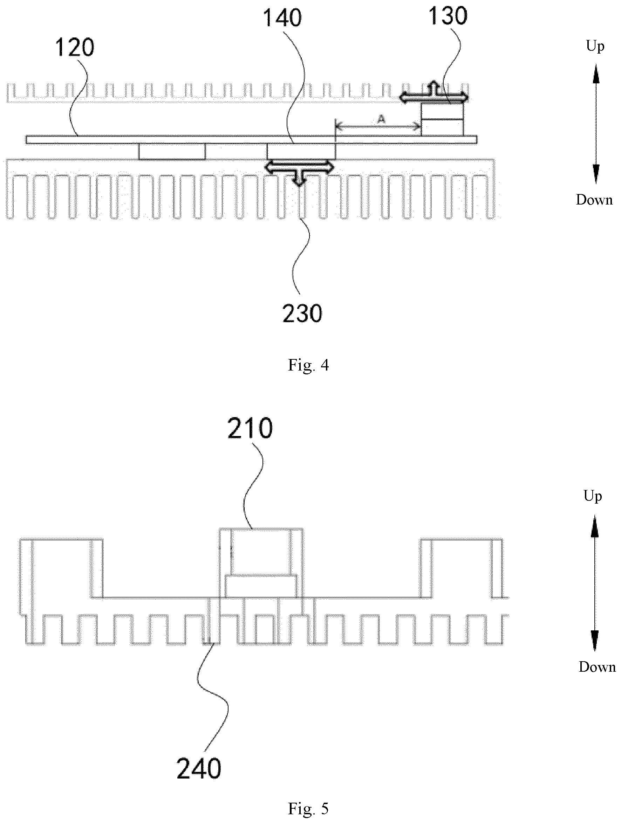

In an embodiment, as shown in Fig. 4, the heat dissipation apparatus further includes a third heat dissipation body 230 arranged on the other side of the first electrical dielectric layer 120. Corresponding to the fact that the first heat source 130 in the previous embodiment is located on one side of the first electrical dielectric layer 120, a second heat source 140 is arranged on the other side of the first electrical dielectric layer 120. The second heat source 140 is connected to the third heat dissipation body 230, so that a heat dissipation channel is formed for the second heat source 140 on the other side of the first electrical dielectric layer 120 to dissipate heat. Therefore, respective heat dissipation channels of the first heat source 130 and the second heat source 140 do not affect each other (referring to the arrow direction in Fig. 4), to realize partitioned heat dissipation, thereby avoiding the problem of thermal cascade. Meanwhile, laying of wirings related to the first electrical dielectric layer 120 or adjustment of a distance A between laid related wirings (shown in Fig. 4) can be facilitated.

In an embodiment, the first heat dissipation body 210 is further provided with first heat dissipation teeth 240 configured to increase the heat dissipation area, and the heat dissipation capability of the first heat dissipation body 210 can be further improved by the first heat dissipation teeth 240. The installation manner and number of the first heat dissipation teeth 240 are not limited, and may be determined according to the actual application situations, for example, reference may be made to the following embodiments.

### Embodiment one

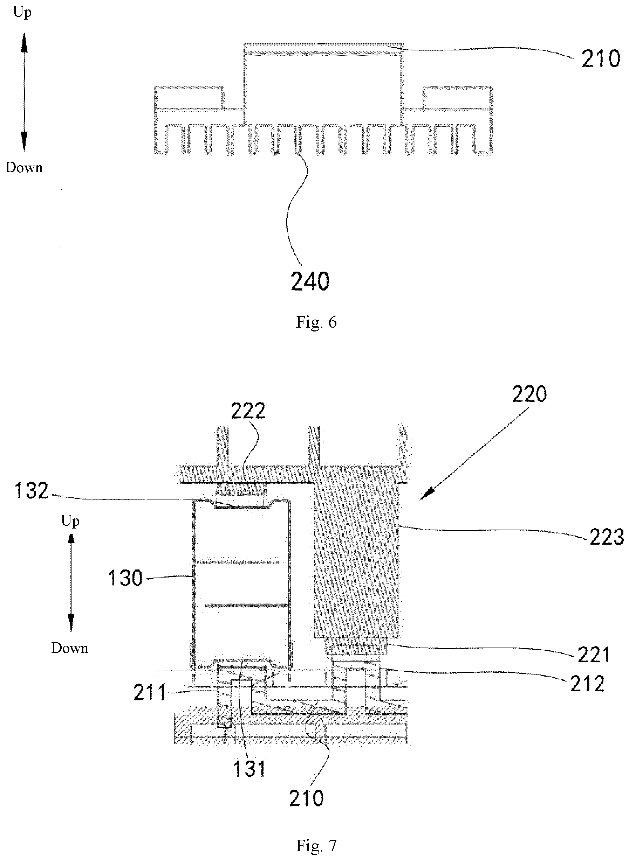

Referring to Fig. 5, for air-cooled heat dissipation scenarios in a front-rear direction, the first heat dissipation teeth 240 may be provided in a same direction as an air duct, to improve the heat dissipation capability of the first heat dissipation body 210 in the air-cooled heat dissipation scenarios in the front-rear direction. Alternatively, referring to Fig. 6, for the air-cooled heat dissipation scenarios in a left-right direction, the first heat dissipation teeth 240 may also be provided in the same direction the air duct, to improve the heat dissipation capability of the first heat dissipation body 210 in the air-cooled heat dissipation scenarios in the left-right direction. Similarly, for the air-cooled heat dissipation scenarios in other directions, the installation positions of the first heat dissipation teeth 240 may be correspondingly set, which will not be repeated here to avoid redundancy.

Referring to Fig. 7, in the case where the first electrical dielectric layer is further provided with a second through hole, the heat dissipation apparatus further includes a second heat dissipation body 220, the first heat dissipation body 210 is further provided with a second heat dissipation column 212, and the second heat dissipation column 212 is configured to pass through the second through hole to be connected to the second heat dissipation body 220.

In an embodiment, by arranging the second heat dissipation column 212 on the first heat dissipation body 210, the first heat dissipation column and the second heat dissipation column 212 can be arranged on the first heat dissipation body 210 simultaneously, such that a heat dissipation bridge is formed on the first heat dissipation body 210 to accelerate heat dissipation for the first heat source 130. In particular, the second heat dissipation body 220 is further provided, so that heat accumulated on the first heat dissipation body 210 and transmitted by the first heat source 130 can be further transferred, thereby further improving a heat dissipation effect for the first heat source 130.

In an embodiment, the first heat dissipation body 210 and the second heat dissipation column 212 may be integrally connected or may be detachably connected. The former is suitable for the case where the electric module is fixed, that is, the heat dissipation apparatus is specially configured to be matched with the electric module. It can be understood that integrated connection enables the heat dissipation apparatus to be matched with the existing electric module conveniently, helping to improve the product quality of the heat dissipation apparatus. While the latter is suitable for processing and thus can allow the heat dissipation apparatus to be matched with different electrical modules, that is, positions of the first heat dissipation body 210 and the second heat dissipation column 212 with respect to each other can be adapted to a corresponding electrical module by adjusting processing. For example, the first heat dissipation body 210 may be set in any three-dimensional shape, such as a rectangular body, a square body, a column body or the like. Similarly, the first heat dissipation column may be installed at any position on the first heat dissipation body 210, and may be connected to the first heat dissipation body 210 at a certain angle. It can be understood that the first heat dissipation body 210 and the first heat dissipation column 211 of the heat dissipation apparatus can be detachably connected to facilitate further processing, thereby improving the product quality of the heat dissipation apparatus.

In an embodiment, the second heat dissipation column 212 may also be provided in multiple, and the specific number may be set according to the actual application situations. In this case, all the second heat dissipation columns 212 may be matched with corresponding through holes respectively to provide a heat dissipation channel for a heat source configured for a corresponding through hole, which, on the whole, further improves the service performance of the electrical module and the device.

In order to describe the principles of some of the above embodiments more accurately, embodiments are also given below.

### Embodiment two

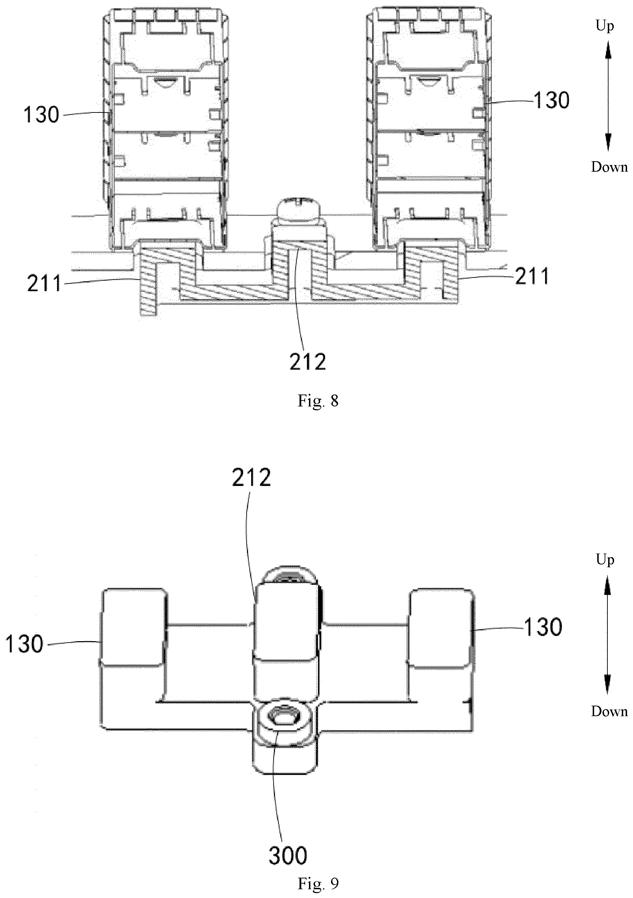

Referring to Fig. 8, two first heat sources 130 are provided, and a single second heat dissipation column 212 is used in cooperation with a pair of first heat dissipation columns 211, that is, one first heat dissipation column 211 and the second heat dissipation column 212 are applied to one heat source component, and the other first heat dissipation column 211 and the second heat dissipation column 212 are applied to another heat source component. Thus, the second heat dissipation column 212 can be shared by different heat source components, to reduce device costs and installation difficulties.

### Embodiment three

Referring to Fig. 9, in the case where the second heat dissipation column 212 is shared by different heat source components, it is required to ensure the stability of the structure during setting. Therefore, both sides of the second heat dissipation column 212 are fixed, that is, a connection between the first heat dissipation body and the first electrical dielectric layer is achieved by a fixing element or in any fixing manner, so that he first heat dissipation column 211 and the second heat dissipation column 212 arranged on the first heat dissipation body are fixed. The fixing element may be selected at random, for example, the connection may be achieved adopting a nut 300 shown in Fig. 9 or a similar component, or adopting manners such as welding, riveting, etc., which is not limited in this embodiment.

### Embodiment four

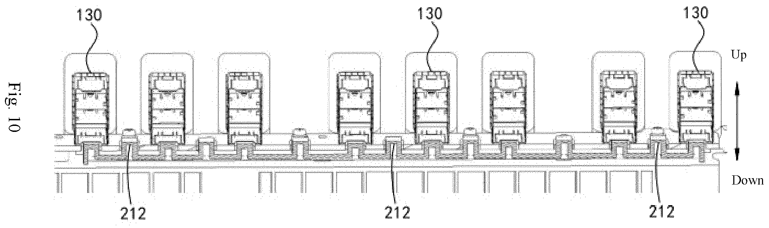

By further expanding on the basis of the embodiment shown in Fig. 9, a structure as shown in Fig. 10 can be obtained. The first heat sources 130 is set into a squirrel cage structure and is provided in multiple, and distances between different first heat sources 130 are set to be different. Accordingly, the distance between a second heat dissipation column 212 and a matched first heat sources 130 varies. It can be seen that even if a second heat dissipation column 212 sharing mode is adopted, the distances between different second heat dissipation columns 212 can be set according to the device wiring requirements, thus meeting the device setting conditions.

In an embodiment, the second heat dissipation body is further provided with second heat dissipation teeth configured to increase the heat dissipation area, and the heat dissipation capability of the second heat dissipation body can be further improved by the second heat dissipation teeth. Since the second heat dissipation teeth in this embodiment belong to the same inventive concept as the first heat dissipation teeth in the embodiments shown in Figures 5 and 6, for the specific implementation of the second heat dissipation teeth in this embodiment, reference may be made to the specific implementation of the first heat dissipation teeth in the above embodiments. To avoid redundancy, the detailed implementation of the second heat dissipation teeth in this embodiment is not repeated here.

In an embodiment, the second heat dissipation body 220 is provided with a first heat dissipation surface 221 connected to the second heat dissipation column 212. As shown in Fig. 7, heat accumulated on the first heat dissipation body and transferred by the first heat source 130 can be further transferred through the first heat dissipation surface 221, that is, the second heat dissipation body 220 provides a heat dissipation channel for the first heat source 130, so that a heat dissipation effect for the first heat source 130 can be further improved. The first heat dissipation surface 221 may cover the second through hole, such that the second heat dissipation column 212 can be connected to the first heat dissipation surface 221 by passing through the second through hole. Therefore, the installation is more convenient.

In an embodiment, the second heat dissipation body 220 is further provided with a second heat dissipation surface 222 connected to the first heat source 130. In the embodiment shown in Fig. 7, the second heat dissipation surface 222 is connected to the first heat source 130, so that the first heat source 130 can also dissipate heat through the second heat dissipation surface 222. In other words, the second heat dissipation body 220 provides another heat dissipation channel for the first heat source 130, so that the first heat source 130 has two independent heat dissipation channels, which further improves the heat dissipation performance of the first heat source 130. Especially for module components connected in a cascade manner, for example, for the multiple layers of optical modules mentioned in the above embodiment, it is equivalent to providing an independent heat dissipation channel for each layer of optical module, thus reducing the influence caused by excessive thermal resistance of unidirectional heat transfer, so that each layer of optical module can have good heat dissipation performance.

In an embodiment, more specifically, the first heat source 130 includes a first surface 131 and a second surface 132 which are oppositely arranged. The first heat dissipation column 211 is connected to the first surface 131, and the second heat dissipation body 220 is connected to the second surface 132. As shown in Fig. 7, the oppositely arranged first surface 131 and second surface 132 of the first heat source 130 are connected to corresponding heat dissipation structures, respectively. Thus, heat dissipation can be performed for the first heat source 130 through both the first surface 131 and the second surface 132, thereby establishing two independent opposite heat dissipation channels for the first heat source 130 to realize two-way heat dissipation, which can significantly improve the heat dissipation efficiency and stability as compared with the one-way heat dissipation in the traditional technology.

In an embodiment, the first heat dissipation column 211 and the second heat dissipation column 212 may be set to have identical specifications, or may be set according to actual situations. The specifications here may include, but not limited to, size, height, an angle formed with the heat dissipation apparatus, etc. For example, in the embodiment shown in Fig. 7, the second heat dissipation column 212 and the first heat dissipation column 211 have identical specifications. To be specific, a joint between the first heat dissipation column 211 and the first surface 131 is higher than that between the second heat dissipation column 212 and the first heat dissipation surface 221. Meanwhile, the other heat dissipation surface of the second heat dissipation body 220 is connected to the second surface 132. Therefore, there is a height difference between different heat dissipation surfaces of the second heat dissipation body 220, so that the heat dissipation surfaces are required to be levelled to keep the overall structure of the second heat dissipation body 220 stable. As shown in Fig.7, as a fixing structure, an intermediate connection portion 223 of the second heat dissipation body 220 has a cross section that is parallel to that of the first heat source 130. Similarly, if the first and second heat dissipation columns 211 and 212 have different specifications, a structure of the second heat dissipation body 220 may be correspondingly set, so as to match the first heat dissipation body and the first heat source 130, which will not be repeated here.

In an embodiment, the heat dissipation apparatus further includes a first heat conduction pad and a second heat conduction pad. The first heat dissipation column is connected to the first surface through the first heat conduction pad, and the second heat dissipation body is connected to the second surface through the second heat conduction pad. By arranging the first heat conduction pad and the second heat conduction pad, heat from the first surface can be stably transmitted to the first heat dissipation column, and heat from the second surface can be stably transmitted to the second heat dissipation body, thus ensuring the stability of dissipated heat transfer. Moreover, the heat conduction pads have a cushioning function, so that each surface has a cushioning function when being connected to a corresponding dissipation structure, preventing the situation of failed matching and connection.

In addition, an embodiment of the present disclosure further provides an electronic device. The electronic device includes the electrical module as shown in the embodiment in Fig. 1 and the heat dissipation apparatus as shown in the above embodiments. A first heat dissipation column of the heat dissipation apparatus passes through a first through hole to be connected to a first heat source. In the electronic device, by arranging the first heat dissipation column capable of passing through the first through hole on the first heat dissipation body, the first heat source arranged on the electrical module of the first electrical dielectric layer can be directly connected to the first heat dissipation column to realize heat dissipation. To be specific, in the case where the first heat source is located on one side of the first electrical dielectric layer, the heat dissipation apparatus may be installed on the other side of the first electrical dielectric layer to dissipate heat from the first heat source, such that the first heat dissipation body and the first heat source can be arranged on opposite sides of the first electrical dielectric layer. Since the heat dissipation apparatus is already arranged on one side of the first heat source in this case, a radiator is not required to be installed on the other side of the first heat source to dissipate heat from the first heat source, thereby solving the problem of obstructing the installation of radiators on other module devices caused by installing a heat radiator at the top of one module device in some technical schemes.

Since the electronic device in this embodiment belongs to the same inventive concept as the electrical module and heat dissipation apparatus in the above-mentioned embodiment, for the specific implementation of the electronic device in this embodiment, reference may be made to the specific implementation of the electrical module and heat dissipation apparatus in the above-mentioned embodiment. In order to avoid redundancy, the specific implementation of the electronic device in this embodiment is not repeated here.

An embodiment of the present disclosure includes: a heat dissipation apparatus applied to an electrical module. The heat dissipation apparatus includes a first heat dissipation body provided with a first heat dissipation column, the first heat dissipation column being configured to pass through a first through hole to be connected to a first heat source. The electrical module includes a first electrical dielectric layer, the first electrical dielectric layer is provided with the first heat source and the first through hole, and the first heat source covers the first through hole. According to the schemes provided by the embodiments of the present disclosure, by arranging a first heat dissipation column capable of passing through a first through hole on a first heat dissipation body, a first heat source arranged on a first electrical dielectric layer can be directly connected to the first heat dissipation column to realize heat dissipation. To be specific, in the case where the first heat source is located on one side of the first electrical dielectric layer, the heat dissipation apparatus may be installed on the other side of the first electrical dielectric layer to dissipate heat from the first heat source, such that the first heat dissipation body and the first heat source can be arranged on opposite sides of the first electrical dielectric layer. Since the heat dissipation apparatus is already arranged on one side of the first heat source in this case, a radiator is not required to be installed on the other side of the first heat source to dissipate heat from the first heat source, thereby solving the problem of obstructing the installation of radiators on other module devices caused by installing a heat radiator at the top of one module device in some technical schemes.

Moreover, the apparatus embodiments described above are merely illustrative, and the units described as separate components may or may not be physically separated, that is, they may be located in one place, or may be distributed onto multiple network elements. Some or all of the modules may be selected according to actual needs to achieve the purpose of the embodiments.

The above is a detailed description of some embodiments of the present disclosure, but the present disclosure is not limited thereto. Those having ordinary skills in the art can also make various equivalent modifications or substitutions without violating the protection scope of this application, and these equivalent modifications or substitutions are included in the protection scope defined by the claims of the present disclosure.

## Claims

1. A heat dissipation apparatus, applied to an electrical module provided with a first heat source, wherein the electrical module comprises a first electrical dielectric layer provided with a first through hole, and the first heat source covers the first through hole, the heat dissipation apparatus comprising:
a first heat dissipation body provided with a first heat dissipation column, the first heat dissipation column being configured to pass through the first through hole to be connected to the first heat source.

2. The heat dissipation apparatus of claim 1, wherein in response to the first electrical dielectric layer being further provided with a second through hole, the heat dissipation apparatus further comprises a second heat dissipation body, the first heat dissipation body is further provided with a second heat dissipation column, and the second heat dissipation column is configured to pass through the second through hole to be connected to the second heat dissipation body.

3. The heat dissipation apparatus of claim 2, wherein the second heat dissipation body is provided with a first heat dissipation surface connected to the second heat dissipation column.

4. The heat dissipation apparatus of claim 3, wherein the second heat dissipation body is further provided with a second heat dissipation surface connected to the first heat source.

5. The heat dissipation apparatus of claim 4, wherein the first heat source comprises a first surface and a second surface which are oppositely arranged, the first heat dissipation column being connected to the first surface, and the second heat dissipation body being connected to the second surface.

6. The heat dissipation apparatus of any one of claims 2 to 5, wherein both the first heat dissipation column and the second heat dissipation column are provided in multiple.

7. The heat dissipation apparatus of claim 5, wherein the heat dissipation apparatus further comprises a first heat conduction pad and a second heat conduction pad, the first heat dissipation column being connected to the first surface through the first heat conduction pad, and the second heat dissipation body being connected to the second surface through the second heat conduction pad.

8. The heat dissipation apparatus of claim 1, wherein the first heat dissipation body is further provided with a first heat dissipation tooth configured to increase the heat dissipation area.

9. The heat dissipation apparatus of claim 2, wherein the second heat dissipation body is further provided with a second heat dissipation tooth configured to increase the heat dissipation area.

10. An electronic device, comprising an electrical module and the heat dissipation apparatus of any one of claims 1 to 9, wherein the electrical module comprises a first electrical dielectric layer provided with a first heat source and a first through hole, and the first heat source covers the first through hole; and the first heat dissipation column of the heat dissipation apparatus passes through the first through hole to be connected to the first heat source.
